# EUROPEAN PATENT APPLICATION

(11) **EP 1 536 497 A2**
(43) Date of publication of application: **01.06.2005**
(21) Application number: 04027988.7
(22) Date of filing: 25.11.2004
(51) Int. Cl.: H01L 51/40, H01L 51/20, H01L 27/15

(54) **Method of manufacturing organic electroluminescent panel, manufacturing apparatus of organic electroluminescent panel, and organic electroluminescent panel**

(30) Priority: 27.11.2003 JP 2003397125
(71) Applicant: SEIKO EPSON CORPORATION, Shinjuku-ku, Tokyo 163-0811 (JP)
(72) Inventor: Yotsuya, Shinichi, Suwa-shi Nagano-ken 392-8502 (JP)
(74) Representative: HOFFMANN - EITLE

(57) **Abstract**

The present invention provides a method of manufacturing an organic EL panel by which highly accurate electro luminescence layers can be formed and in which the attachment and removal between a vapor-deposition mask and a vapor-deposited substrate are easy, a manufacturing apparatus of an organic EL panel with a simple structure for implementing the manufacturing method, and an organic EL panel manufactured with the manufacturing apparatus. A method of manufacturing an organic electro luminescence panel in which a part or all of an electro luminescence layer formed of a plurality of layers is formed by vapor-deposition using a vapor-deposition mask 3, comprises disposing the vapor-deposition mask 3 on a given position on a vapor-deposited substrate (a glass substrate 4) when vapor-depositing, and pressing the vapor-deposited substrate dynamically so as to make the vapor-deposition mask 3 contact the vapor-deposited substrate closely.

## Description

### [Filed of the Invention]

The present invention relates to a method of manufacturing an organic electro luminescence (hereinafter, it is referred to as organic EL) panel, a manufacturing apparatus of an organic EL panel, and an organic EL panel, and particularly to a method of manufacturing an organic EL panel that can form an organic EL layer with high accuracy, a manufacturing apparatus of an organic EL panel for implementing this manufacturing method, and an organic EL panel manufactured with this manufacturing apparatus.

### [Background]

In a conventional manufacturing method of a full-color organic EL display panel, when vapor-depositing light-emitting layers of red, green and blue, three vacuum chambers for vapor-depositing materials corresponding to each color are prepared, and thus a full-color organic EL display panel is manufactured inside these vacuum chambers by using a metal mask whose area is larger and thickness is thinner than those of the organic EL display panel.

Also, in some conventional manufacturing methods of an electro luminescence display, a vapor-deposition mask for vapor-depositing light-emitting layers and so forth is formed of a single crystal silicon wafer. The vapor-deposition mask composed of a single crystal silicon wafer is formed by using semiconductor manufacturing techniques such as photolithography and dry etching, and therefore is processed with high accuracy. In addition, a vapor-deposition mask composed of a single crystal silicon wafer has substantially the same thermal expansion coefficient as that of a glass substrate, which is a vapor-deposited substrate. Therefore, the offset of depositing positions of light-emitting elements and so forth due to thermal expansion when depositing is not caused (for example, refer to Patent Document 1).

Also, in a conventional manufacturing method of an organic EL display panel, when depositing light-emitting layers and so forth, a magnetic material mask or a metal mask is used as a vapor-deposition mask, and then spacers and the vapor-deposition mask are attracted by a substrate holder including a magnet. Thereby, the vapor-deposition mask is aligned with a vapor-deposited substrate with the spacers therebetween (for example, refer to Patent Document 2).

### [Patent Document 1]

Japanese Unexamined Patent Publication No. 2001-185350 (Page 2, FIG. 1).

### [Patent Document 2]

Japanese Unexamined Patent Publication No. 2001-273976 (Page 2, FIG. 4).

### [Disclosure of the Invention]

### [Problem to Be Solved]

In a conventional manufacturing method of a full-color organic EL display panel, when manufacturing a full-color organic EL display panel with large panel size, a metal mask that is correspondingly large needs to be used. However, there is a problem that it is very difficult to manufacture a metal mask whose area is large and thickness is thin.
Moreover, a metal mask has an extremely large thermal expansion coefficient compared to a glass substrate, which is a vapor-deposited substrate. Accordingly, there is a problem that the metal mask expands because of radiant heat when vapor-depositing so that the depositing positions of light-emitting layers and so forth are offset. Particularly, when a large-scale panel of 20-inches or more is fabricated, the offset of depositing positions become large cumulatively, and therefore the problem is serious.

In a conventional manufacturing method of an electro luminescence display device (for example, refer to Patent Document 1), the offset between the positions of a vapor-deposition mask composed of single crystal silicon and a glass substrate, which is a vapor-deposited substrate, due to thermal expansion is not caused. However, since single crystal silicon is nonmagnetic, there is a problem that it is impossible to attract the vapor-deposition mask with a magnet from the backside of the glass substrate so as to make the vapor-deposition mask be in close contact with the vapor-deposited substrate, like the manufacturing method of an organic EL display panel of Patent Document 2. Accordingly, there is a problem that a gap is generated between the glass substrate and the vapor-deposition mask when depositing, and therefore the vapor-deposited material enters the gap, so that the accuracy of deposition pattern is lowered.

Also, in a conventional manufacturing method of an organic EL display panel (for example, refer to Patent Document 2), a magnetic material mask or a metal mask is used as a vapor-deposition mask, and spacers and the vapor-deposition mask are attracted with a magnet form the backside of a glass substrate, which is a vapor-deposited substrate. However, if the vapor-deposition mask is closely contacted with the vapor-deposited substrate with a strong magnet without providing spacers as described in Patent Document 2 for example, the vapor-deposition mask is attached to the vapor-deposited substrate so that they can not be separated from each other easily. Meanwhile, if a magnet is week, a gap is generated between the vapor-deposition mask and the vapor-deposited substrate, and therefore the deposited particles enter the gap, so that the accuracy of deposition pattern is lowered.
Moreover, even when spacers as described in Patent Document 2 are provided, a problem that the spacers are attached to the vapor-deposited substrate or the like may be caused. Also, there is a problem that the handling of the spacers and the deposition process are complicated, and thus increasing cost.

The present invention is intended to provide a method of manufacturing an organic EL panel by which highly accurate electro luminescence layers can be formed and in which the attachment and removal between a vapor-deposition mask and a vapor-deposited substrate are easy, a manufacturing apparatus of an organic EL panel with a simple structure for implementing the manufacturing method, and an organic EL panel manufactured with the manufacturing apparatus.

### [Means to Solve the Problem]

A method of manufacturing an organic electro luminescence panel according to the present invention is a method of manufacturing an organic electro luminescence panel in which a part or all of an electro luminescence layer formed of a plurality of layers is formed by vapor-deposition using a vapor-deposition mask. The method comprises: disposing the vapor-deposition mask on a given position on a vapor-deposited substrate when vapor-depositing; and pressing the vapor-deposited substrate dynamically so as to make the vapor-deposition mask contact the vapor-deposited substrate closely.
Since a vapor-deposition mask is contacted with a vapor-deposited substrate closely by pressing the vapor-deposited substrate dynamically, a gap is not generated between the vapor-deposition mask and the vapor-deposited substrate when vapor-depositing so that the accuracy of vapor-deposition pattern can be enhanced.
In addition, since the vapor-deposited substrate is classical-dynamically pressed without using magnetic force and electric force so as to be contacted with the vapor-deposition mask closely, it is avoided that the vapor-deposition mask attaches to the vapor-deposited substrate and they are never separated from each other.

In the method of manufacturing an organic electro luminescence panel according to the present invention, one weight or a plurality of weights is used as means for dynamically pressing.
If one weight or a plurality of weights is used as a means for dynamically pressing, a vapor-deposition mask is closely contacted with a vapor-deposited substrate easily, and furthermore highly accurate electro luminescence layers can be formed with a simple manufacturing apparatus.
Moreover, if a plurality of weights whose size is smaller than that of the vapor-deposited substrate, even when there are variations in the flatness of the vapor-deposited substrate, the vapor-deposition mask is closely contacted with the vapor-deposited substrate easily.

In the method of manufacturing an organic electro luminescence panel according to the present invention, the means for dynamically pressing includes one elastic body or a plurality of elastic bodies, and presses the vapor-deposited substrate via the elastic body.
The means for dynamically pressing includes one elastic body or a plurality of elastic bodies, and presses the vapor-deposited substrate elastically with the elastic body. Therefore, the vapor-deposited substrate can be prevented from being damaged. In addition, even when there are variations in the flatness of the vapor-deposited substrate, the vapor-deposition mask is closely contacted with the vapor-deposited substrate accurately.

In the method of manufacturing an organic electro luminescence panel according to the present invention, a plunger pin is attached to the elastic body, the plunger pin being brought into contact with the vapor-deposited substrate so as to press the vapor-deposited substrate.
Since a plunger pin is attached to the elastic body, even when there are variations in the flatness of the vapor-deposited substrate, the vapor-deposition mask is closely contacted with the vapor-deposited substrate accurately.
If a plunger pin that moves only along a specific direction (vertical direction and so forth) is contacted with the vapor-deposited substrate so as to press it, for example, given positions of the vapor-deposited substrate can be pressed accurately.

In the method of manufacturing an organic electro luminescence panel according to the present invention, the vapor-deposition mask is composed of single crystal silicon for which given processing is carried out.
As above, since the vapor-deposited substrate is classical-dynamically pressed without using magnetic force and electric force so as to be contacted with the vapor-deposition mask closely, the vapor-deposition mask composed of single crystal silicon, which is not a metal or magnetic material, can be used. In addition, if the vapor-deposition mask is formed by photolithography, dry etching and so forth, a highly accurate vapor-deposition mask can be manufactured, so that a highly accurate deposition pattern can be formed.

A manufacturing apparatus of an organic electro luminescence panel according to the present invention comprises the means for dynamically pressing for implementing any of the above methods of manufacturing an organic electro luminescence panel.
Since the manufacturing apparatus includes the means for classical-dynamically pressing that does not use magnetic force and electric force, and press the vapor-deposited substrate with the means for pressing so as to make the vapor-deposition mask contact the vapor-deposited substrate closely. Accordingly, the accuracy of vapor-deposition pattern can be enhanced, and it is avoided that the vapor-deposition mask attaches to the vapor-deposited substrate and they are never separated from each other.
The means for dynamically pressing is not limited to the above weights but may be such a body as can be attached to the manufacturing apparatus directly.

An organic electro luminescence panel according to the present invention is manufactured with the above manufacturing apparatus of an organic electro luminescence panel.
The organic electro luminescence panel is manufactured with a manufacturing apparatus including the above means for dynamically pressing, and therefore has a highly accurate vapor-deposition pattern of electro luminescence layers and has less defect and damage.

### [Brief Description of the Drawings]

FIG. 1 is a conceptual diagram showing a manufacturing method and a manufacturing apparatus of an organic EL panel according to a first embodiment.
FIG. 2 is a conceptual diagram magnified about a part of a vapor-deposition mask, a glass substrate and a weight of FIG. 1.
FIG. 3 is a schematic diagram showing a process prior to vapor-deposition for a glass substrate in the first embodiment.
FIG. 4 is a schematic diagram showing a process subsequent to the process of FIG. 3.
FIG. 5 is a schematic diagram showing a process subsequent to the process of FIG. 4.
FIG. 6 is a schematic diagram showing a manufacturing apparatus of an organic EL panel according to a second embodiment of the present invention.
FIG. 7 is a schematic diagram showing a manufacturing apparatus of an organic EL panel according to a third embodiment of the present invention.
FIGs. 8A through 8E are longitudinal sectional views showing a manufacturing process of an organic EL panel according to a fourth embodiment of the present invention.

### [Description of Preferred Embodiments]

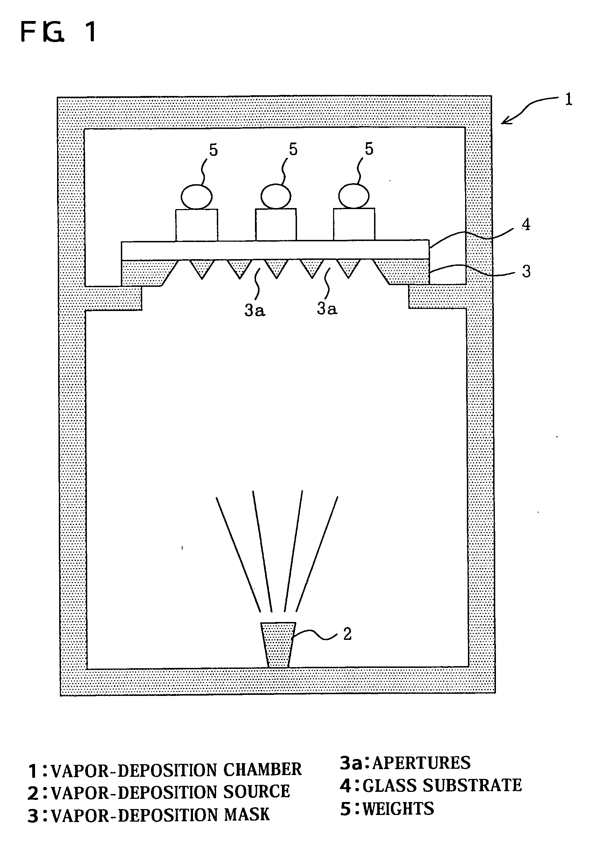

First embodiment
FIG. 1 is a conceptual diagram showing a manufacturing method and a manufacturing apparatus of an organic EL panel according to a first embodiment of the present invention. FIG. 1 shows a longitudinal section of a manufacturing apparatus of an organic EL panel.
A vapor-deposition chamber 1, which is a manufacturing apparatus of an organic EL panel, is used for vacuum deposition for example, and the inside thereof is hermetically sealed. A vapor-deposition source 2 is provided on the bottom side of inside of the vapor-deposition chamber 1. A vapor-deposition mask 3 formed by carrying out given processing for single crystal silicon, for example, with photolithography and etching and so forth is placed above the vapor-deposition source 2 inside the vapor-deposition chamber 1. Apertures 3a with a given shape are formed in the vapor-deposition mask 3 by etching and so forth. The apertures 3a may have the conformation of a number of dot shapes formed corresponding to each pixel of a completed organic EL panel for example. Otherwise, a plurality of apertures 3a of a slot shape may be formed in order to carry out vapor-deposition for pixels of one line arranged vertically or horizontally in a lump.

A glass substrate 4, which is a vapor-deposited substrate, is disposed in a manner of contacting the top surface of the vapor-deposition mask 3. The glass substrate 4 is loaded inside the vapor-deposition chamber 1 before the deposition process, and then is accurately placed on a given position of the top surface of the vapor-deposition mask 3 by an alignment means (not shown).
Before the glass substrate 4 is loaded inside the vapor-deposition chamber 1, wires composed of ITO and so forth, and part of electro luminescence layers (to be described later) in some case, are previously formed on the surface on the lower surface side (the side contacting the vapor-deposition mask 3) of the glass substrate 4.

Furthermore, one or more weights 5, which are means for dynamically pressing, are disposed on the top surface of the glass substrate 4. While FIG. 1 shows that a plurality of weights 5 is disposed, only one weight of a flat plate shape may be disposed for example.
These weights 5 press the glass substrate 4 by means of gravity without using magnetic force and electric force so as to make the vapor-deposition mask 3 contact the glass substrate 4 closely. The means for dynamically pressing in the present invention refers to a means for pressing not by magnetic force and electric force but by force of classical dynamics, and further refers to the weight 5 shown in the first embodiment, a means for mechanically pressing shown in a third embodiment to be described later, or the like.
In this way, after the vapor-deposition mask 3, the glass substrate 4, and the weights 5 are deposited, vapor-deposited materials are evaporated from the vapor-deposition source 2 so as to be deposited on the glass substrate 4, and thus part or all of electro luminescence layers such as light-emitting layers are formed.

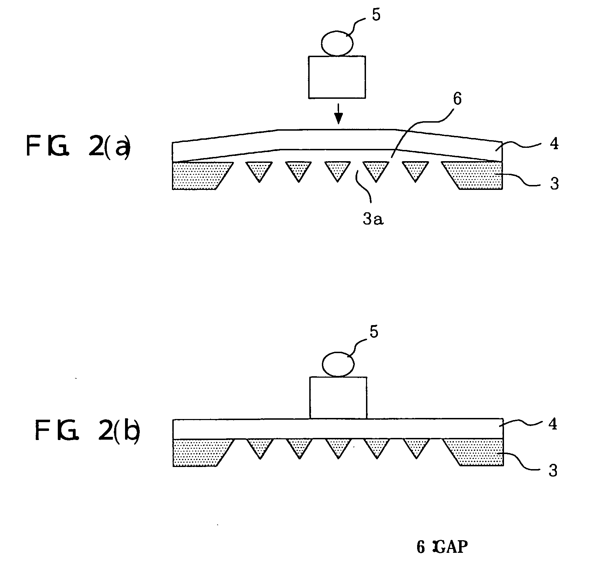

FIG. 2 is a conceptual diagram magnified about parts of the vapor-deposition mask 3, the glass substrate 4, and the weights 5 of FIG. 1. FIG. 2 also shows a longitudinal section of these parts similarly to FIG. 1. Here, only one weight 5 is shown for convenience.
As shown in FIG. 2A, the glass substrate 4, which has been loaded inside the vapor-deposition chamber 1 and has been placed on a given position on the top surface of the vapor-deposition mask 3 by the alignment means, bends considerably because of surface stresses and so forth, and therefore a gap 6 is generated between the vapor-deposition mask 3 and the glass substrate 4. If vapor-deposition is carried out for the glass substrate 4 in this state, the deposited material enters the gap 6 and thus the material is deposited on a part that should be blocked by the vapor-deposition mask normally, so that the accuracy of deposition pattern is lowered. Accordingly, as shown in FIG. 2B, the glass substrate 4 is pressed by disposing the weights 5, which are means for dynamically pressing, on the top surface of the glass substrate 4, and thereby the vapor-deposition mask 3 is contacted with the glass substrate 4 closely. This substantially eliminates the gap 6. Therefore, the vapor-deposited materials can be deposited on a given position so that the accuracy of deposition pattern can be enhanced.

If a plurality of weights 5 whose size is smaller than that of the glass substrate 4 is used, even when there are variations in the flatness of each glass substrate 4, the vapor-deposition mask 3 can be contacted with the glass substrate 4 closely (refer to FIG. 1). In the manufacturing device of an organic EL panel shown in FIG. 1, when vapor-deposition for one glass substrate 4 is completed, the glass substrate is taken outside, and then the next glass substrate 4 is loaded inside the vapor-deposition chamber 1 and vapor-deposition is carried out. When vapor-deposition for the glass substrate 4 is thus carried out in sequence, the flatness (extent of bending) of each glass substrate 4 often involves some variations. At this time, if a plurality of weights 5 whose size is smaller than that of the glass substrate 4 is disposed on the glass substrate 4 as shown in FIG. 1, the pressing corresponding to the flatness of each glass substrate 4 can be implemented. Therefore, even when the flatness of the glass substrate 4 involves some variations, vapor-deposition can be implemented, and thereby reducing the manufacturing cost of the glass substrate 4.

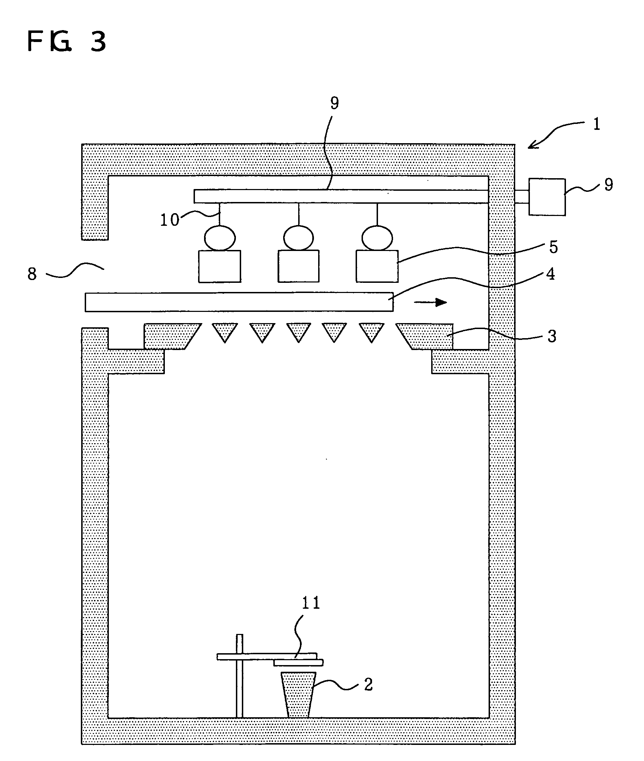

FIGs. 3, 4 and 5 are schematic diagrams showing the processes from the process of loading the glass substrate 4 into the vapor-deposition chamber 1 to the process of vapor-depositing in the first embodiment. Here, FIGs. 3, 4 and 5 show longitudinal sections of the manufacturing apparatus of an organic EL panel similarly to FIG. 1, and show the more specific structure of the manufacturing apparatus of an organic EL panel than FIG.1.
First in the process of FIG. 3, the glass substrate 4 is loaded above the vapor-deposition mask 3 inside the vapor-deposition chamber 1 from an opening 8 for loading a glass substrate of the vapor-deposition chamber 1. As described above, anodes composed of ITO and so forth has been already formed on the lower surface of the glass substrate 4 at this point. At this time, the weights 5 are lifted up above the vapor-deposition mask 3 and the glass substrate 4 by a lifting and lowering means 9 so as not to collide with the glass substrate 4. In the first embodiment, the weights 5 are hung by a wire 10. Also, in the process of FIG. 3, a shutter 11 of the vapor-deposition source 2 is closed and the vapor-deposition source 2 does not heat the vapor-deposited material. The above alignment means (not shown) is used to load the glass substrate 4 inside the vapor-deposition chamber 1.

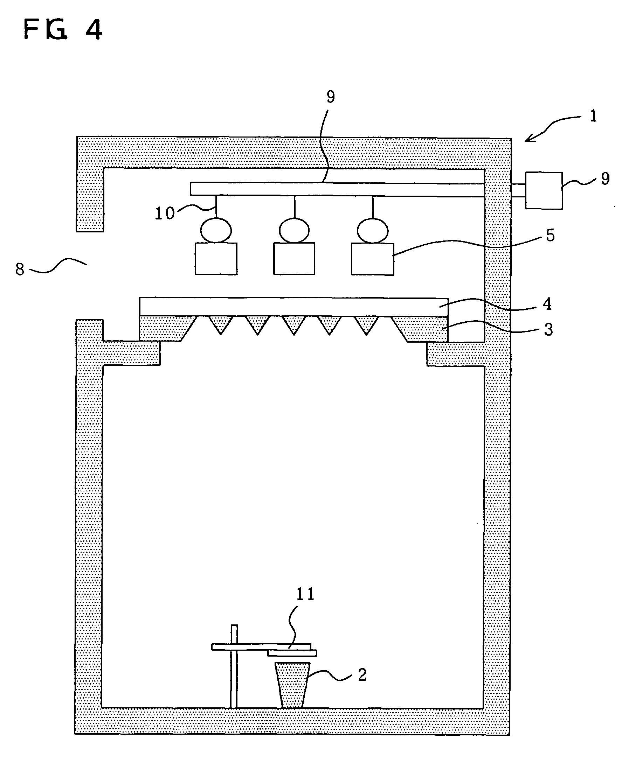

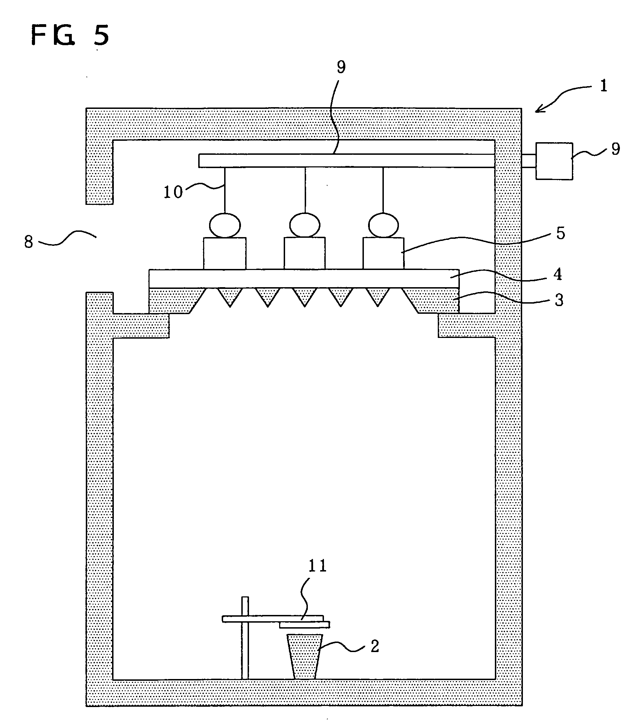

Next, in the process of FIG. 4, the glass substrate 4 is accurately deposited on a given position on the top surface of the vapor-deposition mask 3 by the alignment means (not shown). At this time, the glass substrate 4 is disposed on the vapor-deposition mask 3 so as to contact the vapor-deposition mask 3. At this point, the weights 5 are still lifted up above the vapor-deposition mask 3 and the glass substrate 4 by the lifting and lowering means 9, and the shutter 11 is still closed.
Then, in the process of FIG. 5, the weights 5 are disposed on the top surface of the glass substrate 4 by the lifting and lowering means 9. The glass substrate 4 is pressed by the gravity acting on the weights 5, and thereby the vapor-deposition mask 3 is contacted with the glass substrate 4 closely. The lifting and lowering means 9 may be controlled with an operation panel (not shown) operated by an operator. Otherwise, the weights 5 may be automatically lifted and lowered by the lifting and lowering means 9.
After the process of FIG. 5, the opening 8 for loading a glass substrate is shut off by an openable door (not shown) and then the shutter 11 is opened. Then, the vapor-deposition source 2 is heated to evaporate the vapor-deposited materials, and thereby carrying out vapor-deposition of electro luminescence layers such as light-emitting layers. After the vapor-deposition is completed, the glass substrate 4 is taken outside the vapor-deposition chamber 1.

In the first embodiment, the glass substrate 4, which is a vapor-deposited substrate, is pressed by the weights 5, and thereby the vapor-deposition mask 3 is contacted with the glass substrate 4 closely. Therefore, when depositing, the gap 6 is not generated between the vapor-deposition mask 3 and the glass substrate 4 so that the accuracy of deposition pattern can be enhanced.
In addition, since the glass substrate 4 is classical-dynamically pressed without using magnetic force and electric force so as to be contacted with the vapor-deposition mask 3 closely, it is avoided that the vapor-deposition mask 3 attaches to the glass substrate 4 and they are never separated from each other.

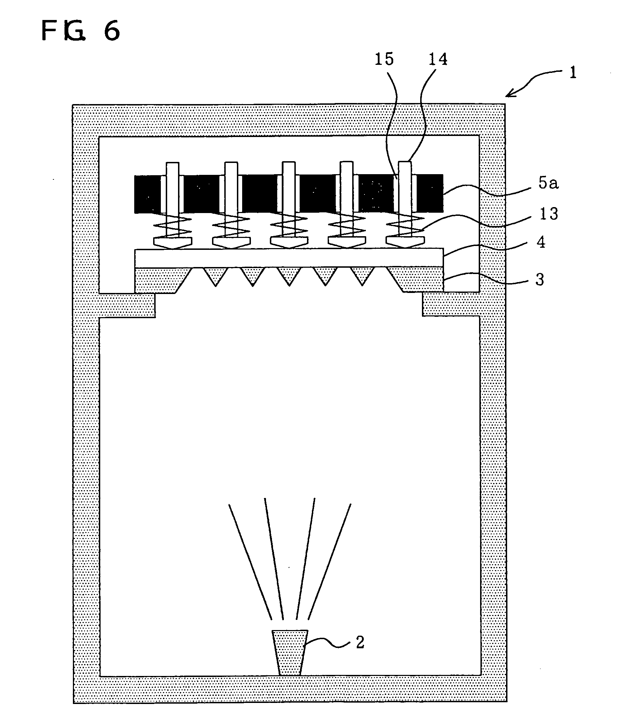

Second embodiment
FIG. 6 is a schematic diagram showing a manufacturing apparatus of an organic EL panel according to a second embodiment of the present invention. FIG. 6 shows a longitudinal section of a manufacturing apparatus of an organic EL panel similarly to FIG. 1 of the first embodiment. The manufacturing apparatus of an organic EL panel according to the second embodiment uses a weight 5a, springs 13, and plunger pins 14 as a means for dynamically pressing. Other features are the same as those of the manufacturing apparatus of an organic EL panel of the first embodiment, and the lifting and lowering means 9, the wire 10, and so forth of FIG. 3 are omitted.

In the manufacturing apparatus of an organic EL panel according to the second embodiment, one weight 5a is provided above the vapor-deposition mask 3 and the glass substrate 4 inside the vapor-deposition chamber 1. A plurality of springs 13 as an elastic body is provided for the weight 5a, and the plunger pins 14 are attached to the springs 13. The plunger pins 14 moves inside tube guides 15 formed in the weight 5a only along the vertical direction. Only one spring 13 and one plunger pin 14 may be provided.

In the second embodiment, after the glass substrate 4 is loaded inside the vapor-deposition chamber 1 so as to be disposed on a given position on the top surface of the vapor-deposition mask 3 by the alignment means (not shown), the weight 5a coupled to the wire 10 (not shown in FIG. 6) is lowered by the lifting and lowering means □ (not shown in FIG. 6). When the weight 5a is lowered, the plunger pins 14 are contacted with the glass substrate 4 so as to press the glass substrate 4 through the springs 13. This makes the vapor-deposition mask 3 be in close contact with the glass substrate 4.
The glass substrate 4 may be pressed by an elastic body such as the springs 13 directly without providing the plunger pins 14. Also, as shown in the third embodiment to be described later, the glass substrate 4 may be pressed by vertically moving the weight 5a with a metal rod or the like by the driving means. Moreover, the glass substrate 4 may be pressed by using a flat plate weight instead of the weight 5a, the springs 13, and the plunger pins 14 and attaching a sponge elastic body to the lower surface of the weight.

In the second embodiment, the weight 5a includes one or more springs 13 so as to press the glass substrate 4 elastically via the springs 13. Therefore, the glass substrate 4 is prevented from being damaged. Furthermore, even when there are variations in the flatness of the glass substrates 4, the vapor-deposition mask 3 can accurately be contacted with the glass substrate 4 closely.
Moreover, since the plunger pins 14 that moves only along a specific direction are contacted with the glass substrate 4 so as to press it, a given position of the glass substrate 4 can accurately be pressed.
Other effects are the same as the first embodiment.

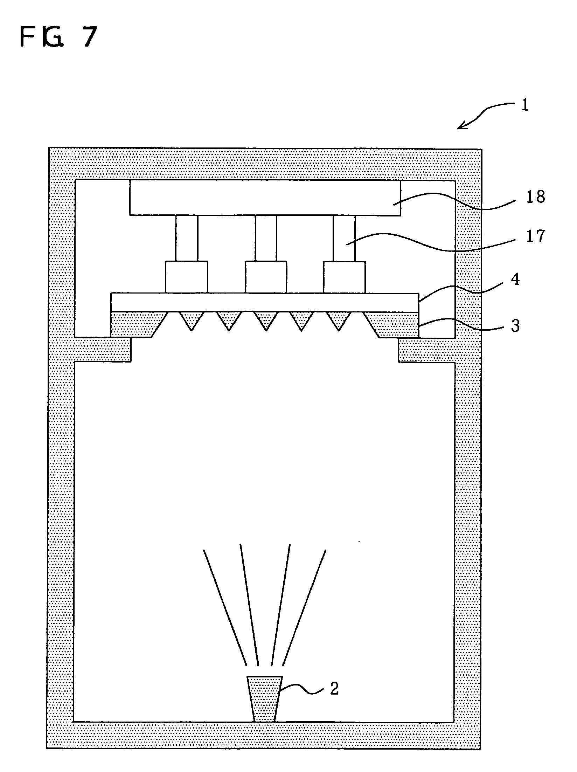

Third embodiment
FIG. 7 is a schematic diagram showing a manufacturing apparatus of an organic EL panel according to a third embodiment of the present invention. FIG. 7 shows a longitudinal section of a manufacturing apparatus of an organic EL panel similarly to FIG. 1 of the first embodiment. The manufacturing apparatus of an organic EL panel according to the third embodiment uses arms 17 and a driving means 18 as the means for dynamically pressing. Other features are the same as the manufacturing apparatus of an organic EL panel of the first embodiment.

In the manufacturing apparatus of an organic EL panel according to the third embodiment, the glass substrate 4 is pressed by means of the arms 17 instead of the weights 5 in the first embodiment. The arms 17 move vertically by means of the driving means 18. For example, the driving means 18 is provided on the top surface of inside of the vapor-deposition chamber 1, and the arms 17 are attached to the vapor-deposition chamber 1 directly. The arms 17 press the glass substrate 4 so as to make the vapor-deposition mask 3 be in close contact with the glass substrate 4.

The driving means 18 may be controlled in such a manner that the arms 17 are moved while an operator monitors the position and so forth of the arms 17. Alternatively, the driving means 18 may be provided with a pressure sensor (not shown) or the like so as to be controlled automatically so that given pressure is placed on the glass substrate 4. As described above, the weight 5a, the springs 13, and the plunger pins 14 as shown in FIG. 6 of the second embodiment may be attached to arms such as metal rods so as to be moved by a driving means.
While the arms 17 and the driving means 18 press the glass substrate 4 classical-dynamically, it will be obvious that electric forth or the like may be used as the driving force for the driving means 18 itself.

In the third embodiment, the glass substrate 4, which is a vapor-deposited substrate, is pressed by the arms 17, and thereby the vapor-deposition mask 3 is contacted with the glass substrate 4 closely. Therefore, when depositing, the gap is not generated between the vapor-deposition mask 3 and the glass substrate 4 so that the accuracy of deposition pattern can be enhanced.
In addition, since the glass substrate 4 is pressed by the arms 17 and the driving means 18 that do not use magnetic force and electric force so as to be contacted with the vapor-deposition mask 3 closely, it is avoided that the vapor-deposition mask 3 attaches to the glass substrate 4 and they are never separated from each other.

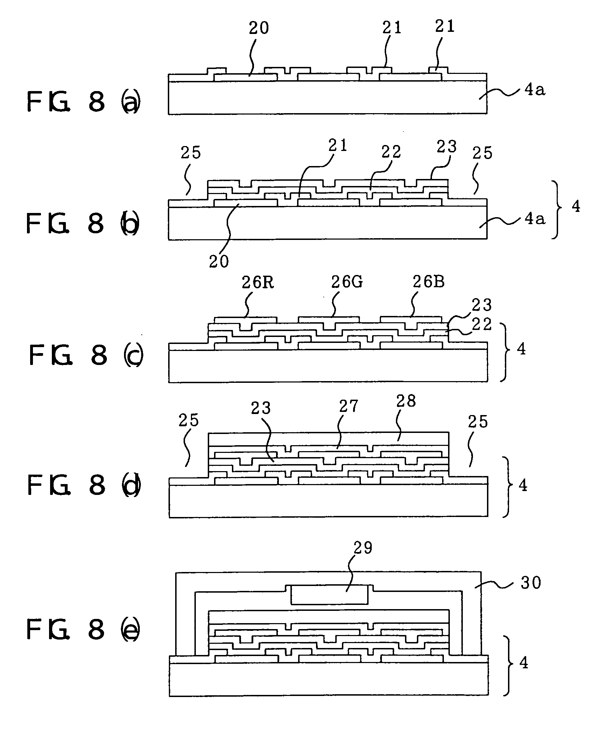

Fourth embodiment
FIGs. 8A through 8E are longitudinal sectional views showing a manufacturing process of an organic EL panel according to a fourth embodiment of the present invention.
While pixels and so forth are schematically illustrated in FIG. 8, a number of pixels are formed in an actual organic EL panel.
This organic EL panel is manufactured with the manufacturing apparatuses of an organic EL panel as shown in the first, second, and third embodiments. While in FIG. 8, an organic EL panel that is a passive driving type and a bottom emission type in which light is emitted toward the alkali-free glass 4a side (lower side in FIG. 8) is shown, an active driving type or top emission type one is also manufactured by using substantially the same manufacturing process, and therefore can be manufactured by using the same manufacturing apparatus of an organic EL panel.

First, anodes 20 composed of indium tin oxide (ITO) are formed on one surface of the alkali-free glass 4a for each pixel by sputtering and so forth, and silicon oxide layers 21 are formed on parts other than the anodes 20 (FIG. 8A). When the anodes 20 and the silicon oxide layers 21 are formed by sputtering, the sputtering may be carried out by using the manufacturing apparatuses of an organic EL panel shown in the first, second and third embodiments.
Then, a hole injection layer 22 and a hole transport layer 23 are vapor-deposited on the top surfaces of the anodes 20 and the silicon oxide layers 21 (FIG. 8B). In the process of FIG. 8B, the hole injection layer 22 and the hole transport layer 23 are vapor-deposited not for each pixel but on the top surfaces of the anodes 20 and the silicon oxide layers 21 excluding a peripheral part 25 in a lump. At this time, a dedicated vapor-deposition mask (not shown) is used in order to shield the peripheral part 25. The manufacturing apparatus of an organic EL panel in the first embodiment and so forth may be used in order to press the vapor-deposition mask.
The alkali-free glass 4a on which the anodes 20, the silicon oxide layers 21, the hole injection layers 22, and the hole transport layers 23 are formed refers to the glass substrate 4. The processes up to FIG. 8B are also carried out for the glass substrate 4 in the first, second and third embodiments.

Then, by using the manufacturing apparatus of an organic EL panel as shown in the first, second and third embodiments, a red light emitting layer 26R, a green light emitting layer 26G and a blue light emitting layer 26B are formed on the top surface of the glass substrate 4 by vapor-deposition (FIG. 8C). At this time, only parts corresponding to light emitting layers of one color are opened as the apertures 3a (refer to FIG. 1) of the vapor-deposition mask 3. For example, after the vapor-deposition for the red light emitting layer 26R is completed, the vapor-deposition mask 3 is moved and the green light emitting layer 26G is vapor-deposited, and then the blue light emitting layer 26B is vapor-deposited similarly. The vapor-deposition process of light emitting layers is carried out by vapor co-depositing a host material and dope material of an organic EL material in general.
Particularly, when vapor-depositing the red light emitting layer 26R, the green light emitting layer 26G and the blue light emitting layer 26B, an highly accurate organic EL panel can be manufactured by pressing the glass substrate 4 so as to make the vapor-deposition mask 3 contact the glass substrate 4 closely.

Thereafter, an electron transport layer 27 is formed on the top surfaces of the hole transport layer 23, the red light emitting layer 26R, the green light emitting layer 26G, and the blue light emitting layer 26B at one time. Moreover, a very thin electron injection layer (not shown) and a cathode 28 composed of aluminum and so forth are formed thereon by sputtering and so forth (FIG. 8D). At this time, by using a dedicated vapor-deposition mask (not shown) similarly to the process of FIG. 8B, it is avoided that the electron transport layer 27 and so forth are deposited on the peripheral part 25. In the present invention, an electro luminescence layer refers to the hole injection layer 22, the hole transport layer 23, the red light emitting layer 26R, the green light emitting layer 26G, the blue light emitting layer 26B, the electron transport layer 27, and the electron injection layer. However, all these layers are not necessarily formed.
Finally, a sealing glass 30 to which a drying agent 29 is attached is joined to the glass substrate 4 on which the electron transport layer 27 and so forth are formed with an adhesive and so forth, and thereby completing an organic EL panel (FIG. 8E).

Although only the red light emitting layer 26R, the green light emitting layer 26G, and the blue light emitting layer 26B are vapor-deposited by using the above manufacturing apparatus of an organic EL panel in the fourth embodiment, the hole injection layer 22 and the hole transport layer 23 may be individually formed for each pixel by using the manufacturing apparatus of an organic EL panel as shown in the first, second and third embodiments. Also, the electron transport layer 27, the electron injection layer, and so forth may be individually formed for each pixel.

The organic EL panel of the fourth embodiment is manufactured with a manufacturing apparatus including a means for dynamically pressing as shown in the first, second and third embodiments, and therefore has a highly accurate vapor-deposition pattern of electro luminescence layers and has less defect and damage.

### [Field of Industrial Application]

The manufacturing method and manufacturing apparatus of an organic EL panel as shown in the first, second and third embodiments of the present invention can also be applied to the fabrication of a color filter in a liquid crystal display by a dye deposition method and the fabrication of an organic transistor and so forth.

### [Reference Numerals]

1: vapor-deposition chamber
2: vapor-deposition source
3: vapor-deposition mask
3a: apertures
4: glass substrate
4a: alkali-free glass
5: weights
5a: weight
6: gap
8: opening for loading a glass substrate
9: lifting and lowering means
10: wire
11: shutter
13: springs
14: plunger pins
15: guides
17: arms
18: driving means
20: anodes
21: silicon oxide layers
22: hole injection layer
23: hole transport layer
25: peripheral part
26R: red light emitting layer
26G: green light emitting layer 26B: blue light emitting layer
27: electron transport layer
28: cathode
29: drying agent
30: sealing glass

## Claims

1. A method of manufacturing an organic electro luminescence panel in which a part or all of an electro luminescence layer formed of a plurality of layers is formed by vapor-deposition using a vapor-deposition mask, comprising:
disposing a vapor-deposited substrate on a given position on the vapor-deposition mask when vapor-depositing; and
pressing the vapor-deposited substrate dynamically so as to make the vapor-deposition mask contact the vapor-deposited substrate closely.

2. The method of manufacturing an organic electro luminescence panel according to Claim 1, wherein one weight or a plurality of weights is used as means for dynamically pressing.

3. The method of manufacturing an organic electro luminescence panel according to Claim 1 or 2, wherein the means for dynamically pressing includes one elastic body or a plurality of elastic bodies, and presses the vapor-deposited substrate via the elastic body.

4. The method of manufacturing an organic electro luminescence panel according to Claim 3, wherein a plunger pin is attached to the elastic body, the plunger pin being brought into contact with the vapor-deposited substrate so as to press the vapor-deposited substrate.

5. The method of manufacturing an organic electro luminescence panel according to any of Claims 1 through 4, wherein the vapor-deposition mask is composed of single crystal silicon for which given processing is carried out.

6. A manufacturing apparatus of an organic electro luminescence panel, comprising the means for dynamically pressing for implementing the method of manufacturing an organic electro luminescence panel according to any of Claims 1 through 5.

7. An organic electro luminescence panel manufactured with the manufacturing apparatus of an organic electro luminescence panel according to Claim 6.
